# EUROPEAN PATENT APPLICATION

(11) **EP 4 734 741 A1**
(43) Date of publication of application: **29.04.2026**
(21) Application number: 25203585.2
(22) Date of filing: 22.09.2025
(51) Int. Cl.: H10W 70/40, H10W 40/25, H10W 90/00, H10W 90/22, H10W 90/20, H10W 40/47, H10W 74/01, H10W 74/10

(54) **POWER MODULES, METHODS FOR MANUFACTURING SAME, AND ELECTRICAL SYSTEMS**

(30) Priority: 29.09.2024 CN 202411375072; 17.09.2025 US 202519331850
(71) Applicant: Shenzhen STS Microelectronics Co., Ltd., Shenzhen 518048 (CN)
(72) Inventor: ZHENG, Nannan, Shenzhen, 518038 (CN); CHEN, Qiao, Shenzhen, 518040 (CN); HUANG, Ming Yue, Shenzhen, 518038 (CN)
(74) Representative: Cabinet Beaumont

(57) **Abstract**

The present disclosure relates to power modules, methods for manufacturing same, and electrical systems. A power module is provided, comprising one or more power module units each comprising: an intra-cooling device formed of an insulating material; a first metal layer disposed on a top surface of the intra-cooling device; a first chip attached on the first metal layer, the first chip being electrically coupled by the first metal layer and at least one of a first conductive clip and a first conductive wire attached on the first chip and the first metal layer; a second metal layer disposed on a bottom surface of the intra-cooling device; and a second chip attached on the second metal layer, the second chip being electrically coupled by the second metal layer and at least one of a second conductive clip and a second conductive wire attached on the second chip and the second metal layer.

## Description

### BACKGROUND

### Technical Field

The present disclosure relates to the field of semiconductor, and more particularly, to power modules, methods for manufacturing same, and electrical systems.

### Description of the Related Art

Conventional power modules typically employ an intra-cooling device (also referred to as an internal heat sink) made of a metal material with good thermal conductivity, and one or more chips are typically disposed on only one side of the intra-cooling device. The one or more chips are attached to a copper-covered ceramic substrate which is further attached to the intra-cooling device, thereby achieving indirect cooling of the one or more chips. However, such power modules have a number of drawbacks, such as low integration, complex electrical coupling mechanism, poor heat dissipation, complex manufacturing process, high difficulty in electrical isolation, and so on.

Accordingly, there is a need for improved power modules and methods for manufacturing same.

### BRIEF SUMMARY

It is one of the objectives of the present disclosure to provide improved power modules and methods for manufacturing the same, and improved electrical systems.

According to an aspect of the present disclosure, there is provided a power module including one or more power module units, each including: an intra-cooling device formed of an insulating material; a first metal layer disposed on a top surface of the intra-cooling device; a first chip attached on the first metal layer, the first chip being electrically coupled by the first metal layer and at least one of a first conductive clip and a first conductive wire attached on the first chip and the first metal layer; a second metal layer disposed on a bottom surface of the intra-cooling device; and a second chip attached on the second metal layer, the second chip being electrically coupled by the second metal layer and at least one of a second conductive clip and a second conductive wire attached on the second chip and the second metal layer.

According to one or more embodiments of the present disclosure, each power module unit further includes: a first conductive pillar attached on the first metal layer to serve as a first signal lead for the first chip; and a second conductive pillar attached on the second metal layer to serve as a second signal lead for the second chip.

According to one or more embodiments of the present disclosure, the power module further comprises: a molded housing formed by integrally fabricating for encapsulating the one or more power module units, wherein one end of the first conductive pillar is exposed from a top surface of the molded housing to serve as a first signal lead contact for the first chip; and wherein one end of the second conductive pillar is exposed from a bottom surface of the molded housing to serve as a second signal lead contact for the second chip.

According to one or more embodiments of the present disclosure, wherein the power module comprises a plurality of power module units arranged in an array; and wherein there is only a portion of the molded housing disposed between adjacent power module units.

According to one or more embodiments of the present disclosure, each power module unit further includes: a first lead attached at an edge location of the first metal layer and extending beyond the first metal layer to serve as a first power supply lead for the first chip; and a second lead attached at an edge location of the second metal layer and extending beyond the second metal layer, to serve as a second power supply lead for the second chip, wherein a portion of the first lead is exposed from a peripheral portion of the molded housing to serve as a first power supply lead contact for the first chip; and wherein a portion of the second lead is exposed from a peripheral portion of the molded housing to serve as a second power supply lead contact for the second chip.

According to one or more embodiments of the present disclosure, wherein a first portion at an edge location of the first metal layer serves as a first power supply lead for the first chip, and a part of the first portion is exposed from a peripheral portion of the molded housing to serve as a first power supply lead contact for the first chip; and wherein a second portion at an edge location of the second metal layer serves as a second power supply lead for the second chip, and a part of the second portion is exposed from a peripheral portion of the molded housing to serve as a second power supply lead contact for the second chip.

According to one or more embodiments of the present disclosure, wherein the intra-cooling device includes: a top insulating part formed by integrally fabricating, including a top cap; a bottom insulating part formed by integrally fabricating, including a box composed of a bottom cap and a plurality of sidewalls surrounding the bottom cap, wherein the top insulating part and the bottom insulating part are assembled together in such a manner that an inner surface of the top cap and an inner surface of the bottom cap face each other, thereby forming a cavity capable of accommodating a cooling liquid; and the cooling liquid accommodated in the cavity.

According to one or more embodiments of the present disclosure, the intra-cooling device further comprises one or all of: at least one first heat conductor, or conductor finger, disposed on the inner surface of the top cap and extending in a direction perpendicular to the inner surface of the top cap; and at least one second heat conductor, or conductor finger, disposed on the inner surface of the bottom cap and extending in a direction perpendicular to the inner surface of the bottom cap.

According to one or more embodiments of the present disclosure, wherein: the at least one first heat conductor and the at least one second heat conductor are arranged in a staggered manner, such that respective heat conductors are spaced apart from each other by a certain distance in the cavity.

According to one or more embodiments of the present disclosure, wherein: the plurality of sidewalls of the bottom insulating part are formed with sealing edges at their locations in contact with the top cap of the top insulating part, the sealing edges being capable of closely mating with edges of the top cap to seal the cavity.

According to one or more embodiments of the present disclosure, wherein the intra-cooling device further comprises: a liquid inlet formed in the top cap of the top insulating part and in the first metal layer, wherein the cooling liquid flows into the cavity through the liquid inlet; and a liquid outlet formed in the top cap of the top insulating part and in the first metal layer, wherein the cooling liquid flows out of the cavity through the liquid outlet.

According to one or more embodiments of the present disclosure, wherein: the at least one first heat conductor and the at least one second heat conductor include one or more of: a cylinder heat conductor, an elliptic cylinder heat conductor, a rectangular cylinder heat conductor, a regular polygonal cylinder heat conductor, an irregular cylinder heat conductor and a cone heat conductor; the attaching comprises bonding together by sintering or welding using an electrically and/or thermally conductive material; the first chip and/or the second chip comprise a power chip; the first metal layer is formed on the top surface of the intra-cooling device by sintering, brazing, soldering or curing; and/or the second metal layer is formed on the bottom surface of the intra-cooling device by sintering, brazing, soldering or curing.

According to still another aspect of the present disclosure, there is provided a manufacturing method for a power module, including: forming one or more power module units, wherein forming each power module unit includes: forming an intra-cooling device from an insulating material; forming a first metal layer and a second metal layer on a top surface and a bottom surface of the intra-cooling device, respectively; attaching a first chip and a second chip on the first metal layer and the second metal layer, respectively; attaching a first conductive clip on the first chip and the first metal layer; and attaching a second conductive clip on the second chip and the second metal layer.

According to one or more embodiments of the present disclosure, forming each power module unit further includes: attaching a first conductive pillar on the first metal layer to serve as a first signal lead for the first chip; and attaching a second conductive pillar on the second metal layer to serve as a second signal lead for the second chip.

According to one or more embodiments of the present disclosure, forming each power module unit further comprises: attaching a first lead at an edge location of the first metal layer, the first lead extending beyond the first metal layer to serve as a first power supply lead for the first chip; and attaching a second lead at an edge location of the second metal layer, the second lead extending beyond the second metal layer to serve as a second power supply lead for the second chip.

According to one or more embodiments of the present disclosure, forming each power module unit further comprises: attaching a first conductive wire on the first chip and the first metal layer; and attaching a second conductive wire on the second chip and the second metal layer.

According to one or more embodiments of the present disclosure, the manufacturing method further includes: collectively disposing the one or more power module units in a lead frame; encapsulating the one or more power module units with a molding compound; and cutting the molding compound and the lead frame to obtain one or more power modules each having a respective molded housing after the molding compound is cured.

According to one or more embodiments of the present disclosure, wherein one end of the first conductive pillar is exposed from a top surface of the molded housing to serve as a first signal lead contact for the first chip; and wherein one end of the second conductive pillar is exposed from a bottom surface of the molded housing to serve as a second signal lead contact for the second chip.

According to one or more embodiments of the present disclosure, the manufacturing method further satisfies one of: wherein a portion of the first lead is exposed from a peripheral portion of the molded housing to serve as a first power supply lead contact for the first chip, and a portion of the second lead is exposed from a peripheral portion of the molded housing to serve as a second power supply lead contact for the second chip; or wherein a first portion at an edge location of the first metal layer serves as a first power supply lead for the first chip and a part of the first portion is exposed from a peripheral portion of the molded housing to serve as a first power supply lead contact for the first chip, and wherein a second portion at an edge location of the second metal layer serves as a second power supply lead for the second chip, and a part of the second portion is exposed from a peripheral portion of the molded housing to serve as a second power supply lead contact for the second chip.

According to still another aspect of the present disclosure, there is provided an electrical system including the power module as described in the foregoing.

Other features and advantages of the present disclosure will become clearer from the following detailed description of illustrative embodiments of the present disclosure with reference to the accompanying drawings.

### BRIEF DESCRIPTION OF THE SEVERAL VIEWS OF THE DRAWINGS

The accompanying drawings, which form a part of the specification, illustrate some embodiments of the present disclosure and together with the specification, serve to explain the principles of the present disclosure.

The present disclosure can be more clearly understood from the following detailed description with reference to the accompanying drawings, in which:
FIG. 1A schematically illustrates a structural schematic diagram of a top view of a power module according to some embodiments of the present disclosure;
FIG. 1B schematically illustrates a structural schematic diagram of a bottom view of the power module of FIG. 1A;
FIG. 2A schematically illustrates a structural schematic diagram of a top view of a power module unit in the power module of FIG. 1A;
FIG. 2B schematically illustrates a structural schematic diagram of a bottom view of a power module unit in the power module of FIG. 1A;
FIG. 3A schematically illustrates a structural schematic diagram of a top view of a power module according to further embodiments of the present disclosure;
FIG. 3B schematically illustrates a structural schematic diagram of a top view of a power module unit in the power module of FIG. 3A;
FIG. 4A schematically illustrates a structural schematic diagram of a top view of a power module according to still further embodiments of the present disclosure;
FIG. 4B schematically illustrates a structural schematic diagram of a bottom view of the power module of FIG. 4A;
FIG. 4C schematically illustrates a structural schematic diagram of a top view of a power module unit in the power module of FIG. 4A;
FIG. 4D schematically illustrates a structural schematic diagram of a bottom view of a power module unit in the power module of FIG. 4A;
FIG. 5 schematically illustrates a cross-sectional view of an intra-cooling device for a power module according to some embodiments of the present disclosure;
FIG. 6A illustrates an exemplary flow diagram of a manufacturing method for a power module according to some embodiments of the present disclosure;
FIG. 6B illustrates an exemplary flow chart of step S304 in the manufacturing method of FIG. 6A; and
FIG. 7 schematically illustrates a schematic diagram of a step for separating the power modules according to some embodiments of the present disclosure.

Note that in the embodiments described below, the same reference numbers are sometimes shared between different drawings to denote the same portions or portions having the same functions, and a repetitive description thereof will be omitted. In some cases, similar items are denoted using similar reference numbers and letters, and thus, once a certain item is defined in a drawing, it does not need to be further discussed in subsequent drawings.

For ease of understanding, positions, sizes, ranges, and the like of the various structures shown in the drawings and the like sometimes do not indicate actual positions, sizes, ranges, and the like. Therefore, the present disclosure is not limited to the positions, sizes, ranges, and the like disclosed in the drawings and the like.

### DETAILED DESCRIPTION

In conventional power modules, one or more chips are attached to a copper-covered ceramic substrate which is further attached to an intra-cooling device made of a metallic material, thereby achieving indirect cooling of the one or more chips. Furthermore, the one or more chips are typically disposed only on one side of the intra-cooling device, and it is necessary to use pins and pin holders or the like to achieve electrical coupling. After research, inventors of the present application found that such power modules have many drawbacks that need to be improved.

First, due to many performance limitations of the intra-cooling device made of a metal material, the one or more chips can be disposed only on one side of the intra-cooling device, so that it is hard to improve the degree of integration of the power module. In addition, the assembly of the one or more chips with the copper-covered ceramic substrate and the intra-cooling device requires the use of pins and pin holders, which results not only in difficulty in further miniaturization of the power module, but also in complicity of the manufacturing process and high cost.

Further, a heat dissipation path from the chip to the copper-covered ceramic substrate and then to the intra-cooling device includes a plurality of alternating metal material layers and ceramic material layers, and there are also a plurality of attachment material layers (e.g., an attachment material layer for attaching the substrate to the intra-cooling device, an attachment material layer for attaching the chip to the substrate, etc.) in the heat dissipation path, resulting in lengthy heat dissipation path and low heat dissipation efficiency. Furthermore, the chip needs to be completely electrically insulated from the intra-cooling device. Although the intra-cooling device made of a metal material can make full use of the thermal conductivity of the metal material, it cannot avoid the difficulty in electrical isolation due to the electrical conductivity of the metal material.

In view of the above problems, inventors of the present application propose completely new technical solutions for improved power modules and methods for manufacturing same, so as to overcome some or all of the above drawbacks.

Some embodiments of the present disclosure will be described in detail below with reference to the accompanying drawings. The following description of at least one exemplary embodiment is merely illustrative in fact and is in no way intended to limit the present disclosure and its applications or uses. That is to say, the structures and methods herein are shown in an exemplary manner to illustrate different embodiments of the structures and methods in the present disclosure. However, those skilled in the art will understand that they merely illustrate exemplary, not exhaustive, manners in which the present disclosure can be implemented.

In all the examples shown and discussed here, the relative arrangement, numerical expressions and numerical values of components and steps set forth in these embodiments do not limit the scope of the present disclosure, unless otherwise specified. In all examples shown and discussed herein, any specific values should be interpreted as exemplary only and not as a limitation. Therefore, other examples of exemplary embodiments can have different values. Furthermore, the drawings are not necessarily drawn to scale, and some features may be exaggerated to show details of specific components.

The technologies, methods and devices known to those skilled in the relevant fields may not be discussed in detail, but in appropriate cases, they should be regarded as part of the granted specification.

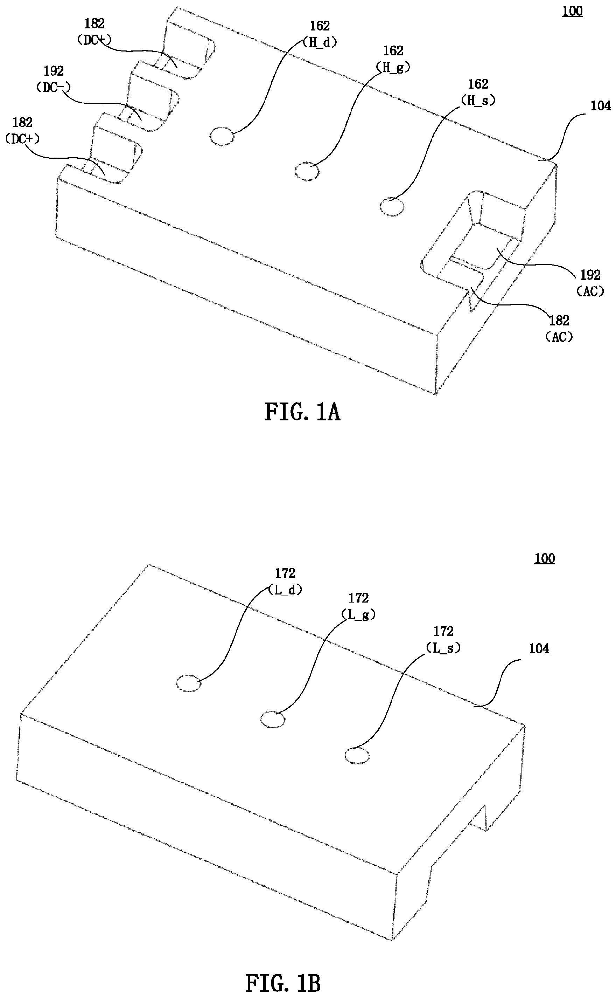

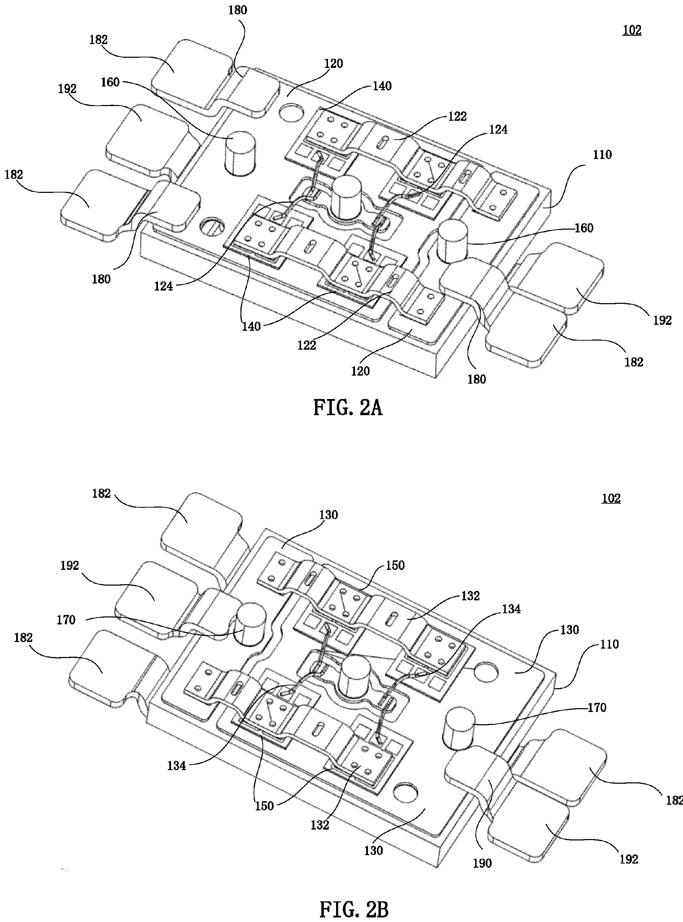

FIG. 1A schematically illustrates a structural schematic diagram of a top view of a power module 100 according to some embodiments of the present disclosure; and FIG. 1B illustrates a structural schematic diagram of a bottom view of the power module 100 of FIG. 1A. The power module is also a power module housing or package. The power module or housing can include one or more power devices or power module units within the power module or housing. To more clearly illustrate the internal structure of the power module 100, FIG. 2A illustrates a structural schematic diagram of a top view of a power module unit or device 102 (i.e., without a molded housing) in the power module 100 of FIGS. 1A and 1B, and FIG. 2B illustrates a structural schematic diagram of a bottom view of the power module unit 102 (i.e., without a molded housing) in the power module 100 of FIGS. 1A and 1B.

The power module 100 according to some embodiments of the present disclosure may comprise one or more power module units 102. As shown in FIG. 2A, each power module unit 102 may include: an intra-cooling device 110 formed of an insulating material; a first metal layer 120 disposed on a top surface of the intra-cooling device 110; and a first chip 140 attached on the first metal layer 120. The first chip 140 may be electrically coupled by the first metal layer 120 and a first conductor, which may be at least one of a first conductive clip 122 and a first conductive wire 124 attached on the first chip 140 and the first metal layer 120. As shown in FIG. 2B, each power module unit 102 according to some embodiments of the present disclosure may further include: a second metal layer 130 disposed on a bottom surface of the intra-cooling device 110; and a second chip 150 attached on the second metal layer 130. The second chip 150 is electrically coupled by the second metal layer 130 and a second conductor, which may be at least one of a second conductive clip 132 and a second conductive wire 134 attached on the second chip 150 and the second metal layer 130. In a preferred embodiment, the first conductive clip 122 and/or the second conductive clip 132 may include a copper clip or the like.

Those skilled in the art will appreciate that, although only one power module unit 102 is shown in FIGS. 2A and 2B, this is merely for clearly illustrating a specific structure of the power module unit and is not intended to be limiting in any way. The power module 100 according to some embodiments of the present disclosure may include any plurality of power module units, and the plurality of power module units may be arranged in an array.

With continued reference to FIGS. 2A and 2B, each power module unit 102 may further include: a first conductive pillar 160 attached on the first metal layer 120 to serve as a first signal lead for the first chip 140; and a second conductive pillar 170 attached on the second metal layer 130 to serve as a second signal lead for the second chip 150.

As shown in FIGS. 1A and 1B, the power module 100 according to some embodiments of the present disclosure may further include a molded housing 104 formed by integrally fabricating, for encapsulating the one or more power module units 102.

In some embodiments, as shown in FIG. 1A, one end of the first conductive pillar 160 is exposed from a top surface of the molded housing 104 to serve as a first signal lead contact 162 for the first chip 140. As shown in FIG. 1B, one end of the second conductive pillar 170 is exposed from a bottom surface of the molded housing 104 to serve as a second signal lead contact 172 for the second chip 150. In some embodiments, the first signal lead contacts 162 may include at least one of, for example, a contact H_d connected to a drain of the first chip 140, a contact H_g connected to a gate of the first chip 140, a contact H_s connected to a source of the first chip 140, and the like, and the second signal lead contacts 172 may include at least one of, for example, a contact L_d connected to a drain of the second chip 150, a contact L_g connected to a gate of the second chip 150, a contact L_s connected to a source of the second chip 150, and the like.

In the power module 100 according to some embodiments of the present disclosure, by using conductive pillars as signal leads in combination with appropriate external connections, the use of pins and pin connectors for electrical coupling as in conventional power modules can be avoided. This not only can reduce the kinds of connectors required to be used in the packaging process, thereby simplifying the packaging process, but also can prevent interlayer peeling of these connection points, thereby improving the interconnection quality of the power module.

With continued reference to FIGS. 2A and 2B, each power module unit 102 according to some embodiments of the present disclosure may further include: a first lead 180 attached at an edge location of the first metal layer 120 and extending beyond the first metal layer 120 to serve as a first power supply lead for the first chip 140; and a second lead 190 attached at an edge location of the second metal layer 130 and extending beyond the second metal layer 130 to serve as a second power supply lead for the second chip 150.

In some embodiments, as shown in FIG. 1A, a portion of the first lead 180 is exposed from a peripheral portion of the molded housing 104 to serve as a first power supply lead contact 182 for the first chip 140; and a portion of the second lead 190 is exposed from a peripheral portion of the molded housing to serve as a second power supply lead contact 192 for the second chip 150. In some embodiments, the first power supply lead contacts 182 may include at least one of, for example, a direct current power supply lead contact (DC+) and alternating current power supply lead contact (AC) connected to the first chip 140, and the second power supply lead contacts 192 may include at least one of, for example, a direct current power supply lead contact (DC-) and alternating current power supply lead contact (AC) connected to the second chip 150.

Those skilled in the art will appreciate that, although specific arrangements of the power supply lead contacts and the signal lead contacts are schematically illustrated in FIGS. 1A and 1B, this is taken as an example only and is not intended to be limiting in any way. The power module according to some embodiments of the present disclosure may include any number, any distribution, any shape, and any size of the above-described contacts.

In some embodiments, when the power module 100 includes a plurality of power module units 102, the plurality of power module units 102 are arranged in an array and are collectively encapsulated, i.e., encapsulated together by the molded housing 104 formed by integrally fabricating as previously described. There is only a portion of the molded housing 104 disposed between adjacent power module units 102 without a residual portion of a lead frame or the like.

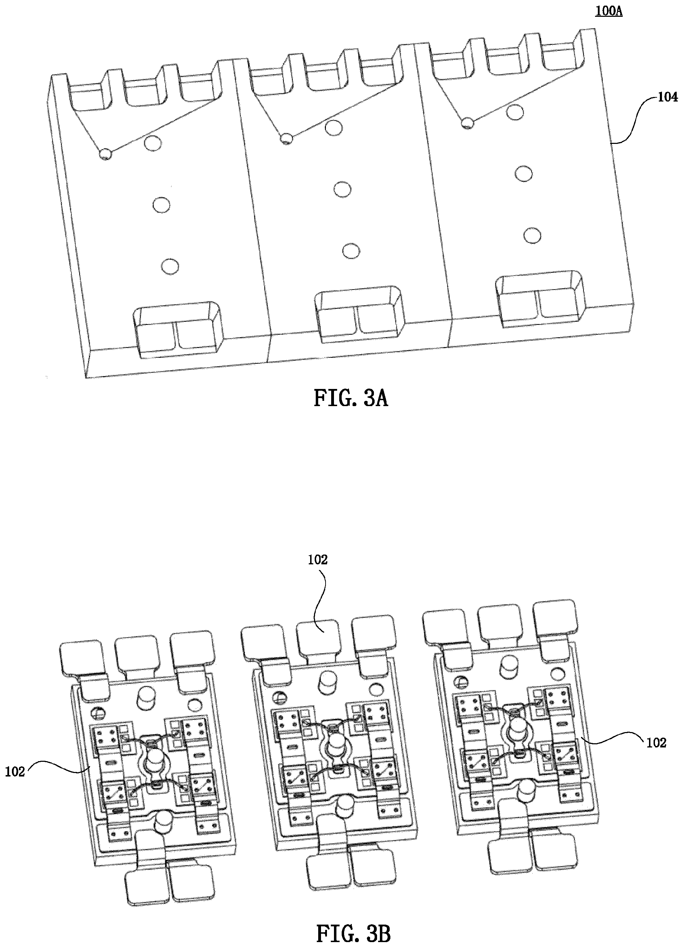

As an example of a power module including a plurality of power module units, FIG. 3A schematically illustrates a structural schematic diagram of a power module 100A according to some further embodiments of the present disclosure, and FIG. 3B schematically illustrates a structural schematic diagram of a top view of power module units 102 in the power module 100A of FIG. 3A. The power module 100A includes a plurality of power module units 102, in which each power module unit 102 has the same structure as the power module unit 102 shown in FIGS. 2A and 2B, and a description thereof will not be repeated herein.

As shown in FIGS. 3A and 3B, the plurality of power module units 102 in the power module 100A are arranged in an array and are encapsulated together by a molded housing 104 formed by integrally fabricating. In contrast, a plurality of power module units of a conventional power module are usually individually packaged and then welded together, which results in welded seams existing between adjacent power module units of the power module, with residual portions of the lead frame remaining. In contrast, the power module 100A according to some embodiments of the present disclosure has only a portion of the molded housing 104 disposed between the adjacent power module units 102, and has neither a welded seam nor a residual portion of the lead frame, etc., so that the volume of the power module 100A is further reduced.

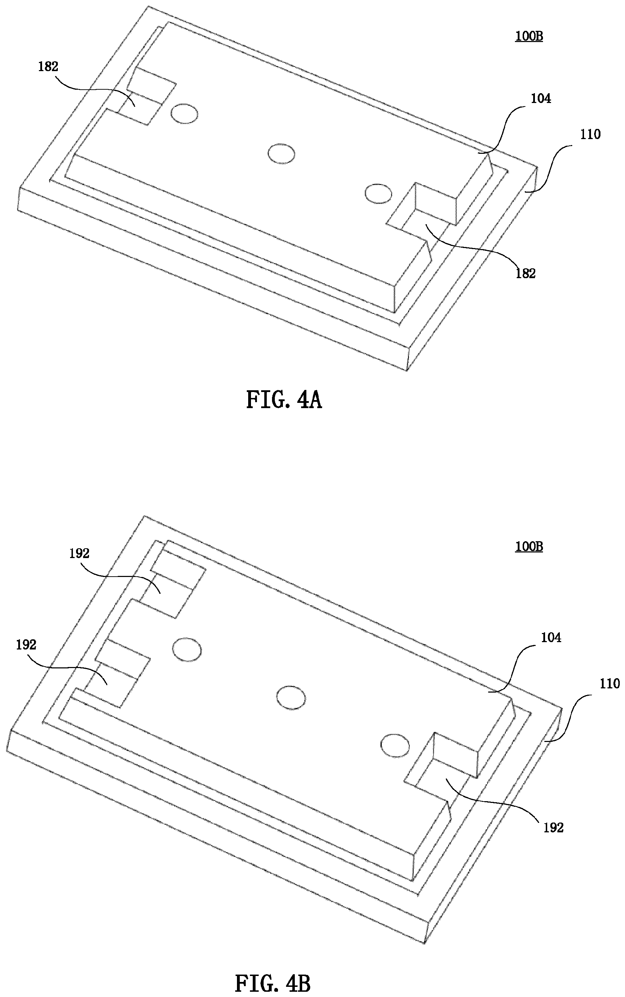

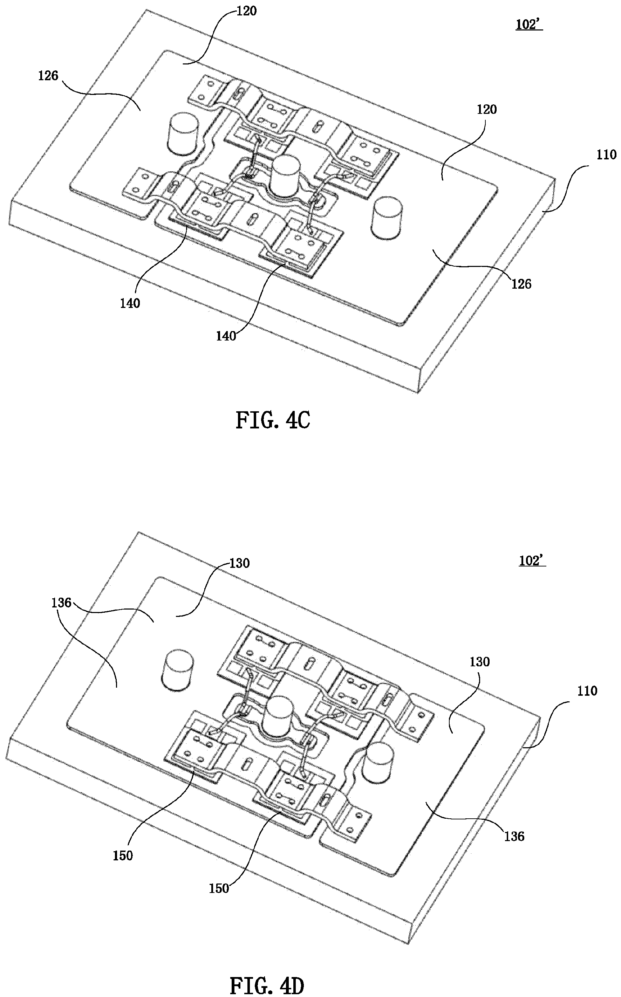

FIG. 4A schematically illustrates a structural schematic diagram of a top view of a power module 100B according to some further embodiments of the present disclosure, and FIG. 4B schematically illustrates a structural schematic diagram of a bottom view of the power module 100B of FIG. 4A. To more clearly illustrate the internal structure of the power module 100B, FIG. 4C illustrates a structural schematic diagram of a top view of a power module unit 102' in the power module 100B of FIG. 4A, and FIG. 4D illustrates a structural schematic diagram of a bottom view of the power module unit 102' in the power module 100B of FIG. 4A. The power module unit 102' is structurally similar to the power module unit 102 shown in FIGS. 2A to 2B, and only different portions of the power module unit 102' from the power module unit 102 will be described here to avoid repeated description.

Compared to the power module unit 102, the main differences of the power module unit 102' according to some embodiments of the present disclosure lie in that, instead of using an additional lead as its power supply lead, a portion of the first metal layer 120 and a portion of the second metal layer 130 are taken as its power supply leads. As shown in FIG. 4A and 4C, a first portion 126 at an edge location of the first metal layer 120 serves as a first power supply lead for the first chip 140, and a part of the first portion 126 is exposed from a peripheral portion of the molded housing 104 to serve as a first power supply lead contact 182 for the first chip 140. As shown in FIGS. 4B and 4D, a second portion 136 at an edge location of the second metal layer 130 serves as a second power supply lead for the second chip 150, and a part of the second portion 136 is exposed from a peripheral portion of the molded housing 104 to serve as a second power supply lead contact 192 for the second chip 150.

In some embodiments, as shown in FIGS. 4A and 4B, the intra-cooling device 110 in the power module may be exposed from the molded housing 104. In other embodiments, as shown in FIGS. 1A, 1B, and 3A, the intra-cooling device 110 may be completely encapsulated in the molded housing 104. Those skilled in the art will appreciate that, whether the intra-cooling device 110 is exposed from the molded housing 104 may be arbitrarily set according to application needs.

It will be understood by those skilled in the art that, although the number, distribution, shape and size of the first chip, the second chip, the conductive pillars, the conductive clips, the conductive wires, the leads, the contacts and the like are schematically illustrated in the various figures, this is merely for the purpose of showing the various components as fully as possible in the same set of figures and is not intended to be limiting in any way. The power module according to some embodiments of the present disclosure may include any number, any distribution, any shape, and any size of the above-described components.

In some embodiments of the present disclosure, "attaching" may refer to, for example, bonding with one another by an electrically and/or thermally conductive material, and may be performed by using processes such as sintering or welding. For example, the first chip 140 may be attached to the first metal layer 120 by an electrically and thermally conductive attachment material layer. For another example, the second chip 150 may be attached to the second metal layer 130 by an electrically and thermally conductive attachment material layer.

In some embodiments, the first chip 140 and/or the second chip 150 may include a power chip.

In some embodiments, the first metal layer 120 may be formed on the top surface of the intra-cooling device 110 by sintering, brazing, soldering, or curing; and/or, the second metal layer 130 may be formed on the bottom surface of the intra-cooling device 110 by sintering, brazing, soldering, or curing.

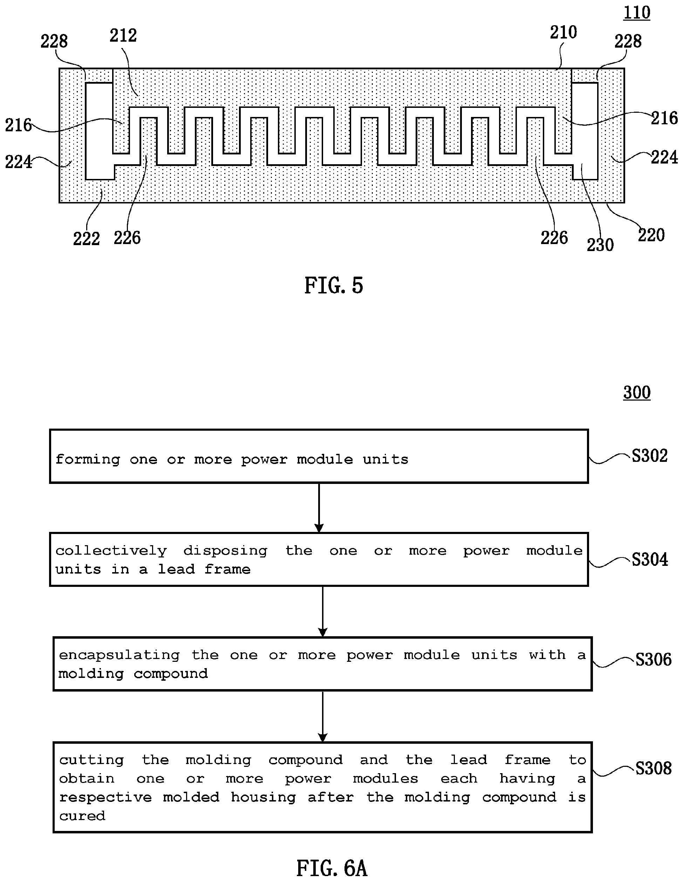

FIG. 5 schematically illustrates a cross-sectional view of an intra-cooling device 110 for a power module according to some embodiments of the present disclosure. The intra-cooling device 110 may be used, for example, in the power module 100/100A/100B according to some embodiments of the present disclosure.

As shown in FIG. 5, the intra-cooling device 110 may include: a top insulating part 210 formed by integrally fabricating, including a top cap 212; a bottom insulating part 220 formed by integrally fabricating, includes a box composed of a bottom cap 222 and a plurality of sidewalls 224 surrounding the bottom cap. The top insulating part 210 and the bottom insulating part 220 are assembled together in such a manner that an inner surface of the top cap 212 and an inner surface of the bottom cap 222 face each other, thereby forming a cavity 230 capable of accommodating a cooling liquid. The intra-cooling device 110 further includes the cooling fluid (not shown) accommodated in the cavity 230. The top insulating part 210 and the bottom insulating part 220 may be made of any suitable insulating material, which may include, for example, an insulating ceramic material or the like.

In some embodiments, the intra-cooling device 110 may also include one or both of: at least one first heat conductor 216, or conductor finger, disposed on the inner surface of the top cap 212 and extending in a direction perpendicular to the inner surface of the top cap 212; and at least one second heat conductor 226, or conductor finger, disposed on an inner surface of the bottom cap 222 and extending in a direction perpendicular to the inner surface of the bottom cap 222. The intra-cooling device 110 illustrated in FIG. 5 includes both the first heat conductors 216 and the second heat conductors 226, but those skilled in the art will appreciate that, the intra-cooling device 110 according to some embodiments of the present disclosure may include only the first heat conductors 216 but not the second heat conductors 226, or only the second heat conductors 226 but not the first heat conductors 216. The first heat conductors 216 and the second heat conductors 226 can increase a contact area between the cooling fluid and the intra-cooling device 110 to promote more sufficient heat exchange therebetween, thereby improving the heat dissipation effect of the cooling device.

In some embodiments, the at least one first heat conductor 216 and the at least one second heat conductor 226 in the cavity 230 may be arranged in a staggered manner with respect to each other, such that respective heat conductors are spaced apart from each other by a certain distance in the cavity 230. The heat conductors arranged in a staggered manner enable the cooling liquid to flow in the tortuous cavity 230 and to be in sufficient contact with respective heat conductors, thereby enabling the cooling liquid to sufficiently absorb heat from the heat conductors to improve heat dissipation efficiency.

Those skilled in the art will appreciate that, while the number, shape, and arrangement of the first and second heat conductors 216 and 226 are illustrated in FIG. 5, this is not intended to be limiting in any way. First, the number of the first heat conductors 216 and the number of the second heat conductors 226 can be arbitrarily set according to application requirements. Moreover, the first heat conductors 216 and the second heat conductors 226 may take any shape, particularly a shape suitable for increasing a contact area with the cooling liquid, including but not limited to one or more of: cylinder heat conductor, elliptical cylinder heat conductor, rectangular cylinder heat conductor, regular polygonal cylinder heat conductor, irregular cylinder heat conductor, cone heat conductor, and the like. Furthermore, the first heat conductors 216 and the second heat conductors 226 may be arranged in any staggered manner with respect to one another, particularly an arrangement adapted to promote the flow of the cooling fluid and the sufficient contact of the cooling fluid with the heat conductors.

In some embodiments, the plurality of sidewalls 224 of the bottom insulating part 220 may be formed with sealing edges 228 at their locations in contact the top cap 212 of the top insulating part 210. The sealing edges 228 project relative to the sidewalls 224, to enable close mating with edges of the top cap 212 to seal the cavity 230. When the sealing edges 228 are mated with the edges of the top cap 212, a waterproof adhesive layer may also be applied at a seam of the two, thereby adequately sealing the cavity. The provision of the sealing edges 228 allows an area of the seam region between the top insulating part and the bottom insulating part to be greatly reduced relative to the conventional intra-cooling device, thereby improving the sealing performance of the intra-cooling device of the present application.

The intra-cooling device according to some embodiments of the present disclosure may further include a liquid inlet (not shown) and a liquid outlet (not shown). For example, the liquid inlet and the liquid outlet may be formed in the top cap of the top insulating part and the first metal layer, wherein the cooling liquid flows into the cavity through the liquid inlet and flows out of the cavity through the liquid outlet.

The power module 100/100A/100B according to some embodiments of the present disclosure and the method of manufacturing the same achieve many improvements over the conventional power modules and methods of manufacturing the same.

First, the degree of integration and miniaturization of the power modules of the present application is significantly improved. Compared to the conventional power modules in which chips are disposed only on a single side of a metal cooling device due to limitations of the metal cooling device, chips can be respectively disposed on both sides of the intra-cooling device by using an efficient intra-cooling device made of an insulating material (e.g., an insulating ceramic material) in the power modules according to some embodiments of the present disclosure. Such a design significantly improves the degree of integration of the power modules on the premise of ensuring the heat dissipation effect, thereby promoting the miniaturization process of the power modules. In addition, the plurality of power module units of a power module of the present application are encapsulated by a molded housing formed by integrally fabricating, thereby avoiding welded seams that exit between adjacent power module units of the conventional power module and residual portions of the lead frame that remain between adjacent power module units of the conventional power module, which further miniaturizes the power module of the present application.

In addition, the effect of electrically coupling of the chips in the power modules is greatly improved compared with the conventional power modules. On the one hand, the power supply leads are molded in the package, which not only optimizes the electrical performance of the power module, but also simplifies the mold design to adapt to the molding process, so that separation or combination of different numbers of power module units can be realized by cutting process in the manufacturing process, thereby meeting different circuit design requirements. On the other hand, by using conductive pillars as signal leads in combination with appropriate external connections, the use of pins and pin connectors for electrical coupling as in the conventional power modules can be avoided, which not only reduces the kinds of connectors that are required to be used in the packaging process, thereby simplifying the packaging process, but also avoids interlayer peeling of these connection points, thereby improving the interconnection quality of the power module.

Furthermore, the power modules of the present application are remarkably improved in heat dissipation efficiency. Conventional intra-cooling devices are typically manufactured using a metal material, and the chip needs to be mounted over the intra-cooling device indirectly through a copper-covered ceramic substrate (the substrate is composed of a ceramic material and copper layers attached on both sides thereof). In contrast, the intra-cooling devices of the present application innovatively use the top and bottom insulating parts formed by an integrally fabricating technique and then assembled, so that the chips can be directly attached to the intra-cooling device through the metal layers disposed on outer surfaces of the top and bottom insulating parts. On one hand, the design shortens a heat dissipation path, so that heat generated by the chip can be more directly conducted to the intra-cooling device. On the other hand, switching between different material layers is reduced, thereby significantly improving the cooling efficiency of the intra-cooling device. In addition, the top and bottom insulating parts of the intra-cooling device not only take on the cooling function, but also serve as the attachment substrates of the chips, so that the use of a copper-covered ceramic substrate is eliminated. This not only significantly reduces the thickness of the power module to further promote the miniaturization process of the power module, but also simplifies the manufacturing process and reduces the manufacturing cost.

Moreover, the intra-cooling device of the present application is composed of the top and bottom insulating parts formed by integrally fabricating respectively, and the seam area between the two integrally-fabricated components is greatly reduced compared with that of the conventional intra-cooling device, thereby realizing better sealing effect on the cooling liquid. Further, since the intra-cooling device of the present application is made of an insulating material (e.g., an insulating ceramic material), it has not only a good electrical isolation effect, but also excellent corrosion and erosion resistance.

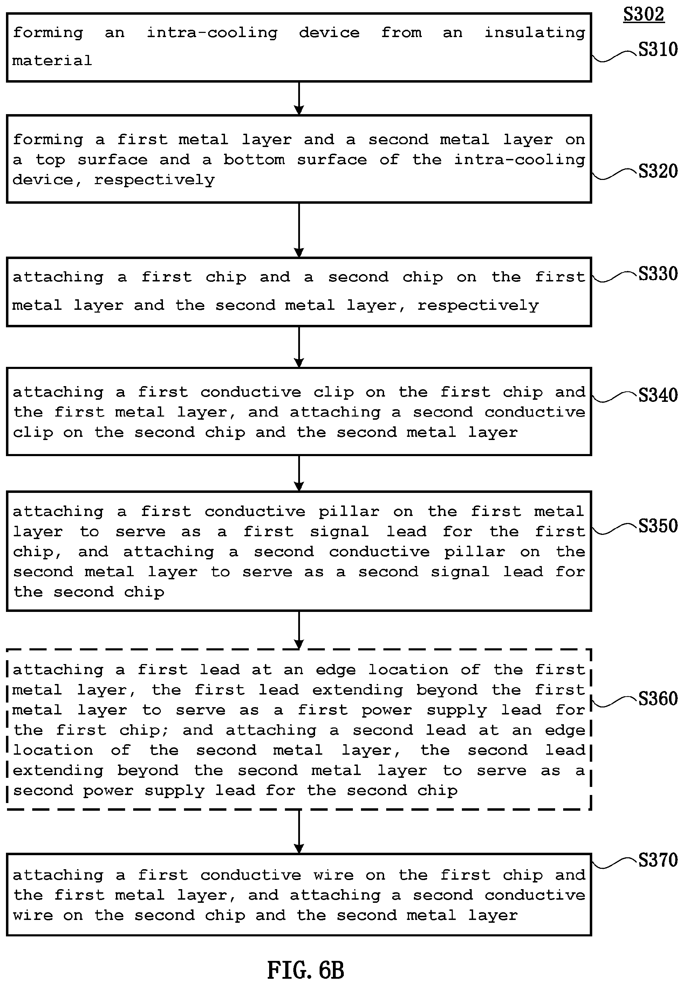

FIG. 6A illustrates an exemplary flow diagram of a manufacturing method 300 for a power module according to some embodiments of the present disclosure, and FIG. 6B illustrates an exemplary flow diagram of step S302 in the manufacturing method 300 of FIG. 6A. Those skilled in the art will appreciate that, the manufacturing method 300 for a power module described in conjunction with FIGS. 6A and 6B may be used to manufacture the power module 100/100A/100B described in accordance with the foregoing embodiments of the present disclosure, and thus the foregoing corresponding description of the power module 100/100A/100B applies here as well.

As shown in FIG. 6A, the manufacturing method 300 for a power module according to some embodiments of the present disclosure may comprise steps S302 to S308.

At step S302, one or more power module units 102/102' are formed, as shown in FIGS. 2A, 2B, 3B, 4C, and 4D.

At step S304, the one or more power module units 102/102' are collectively disposed in a lead frame.

At step S306, the one or more power module units 102/102' are encapsulated with a molding compound.

At step S308, the molding compound and the lead frame are cut after the molding compound is cured, to obtain one or more power modules 100/100A/100B each having a respective molded housing 104, as shown in FIGS. 1A, 1B, 3A, 4A, and 4B.

The manufacturing method 300 according to some embodiments of the present disclosure can significantly improve manufacturing efficiency, compared to conventional manufacturing methods for a power module. Specifically, the manufacturing method for a power module of the present application first arranges a plurality of power module units in an array in a lead frame, then collectively encapsulates all the power module units with a molding compound, and then cuts the cured molding compound, thereby obtaining one or more power modules each having a respective molded housing formed by integrally fabricating.

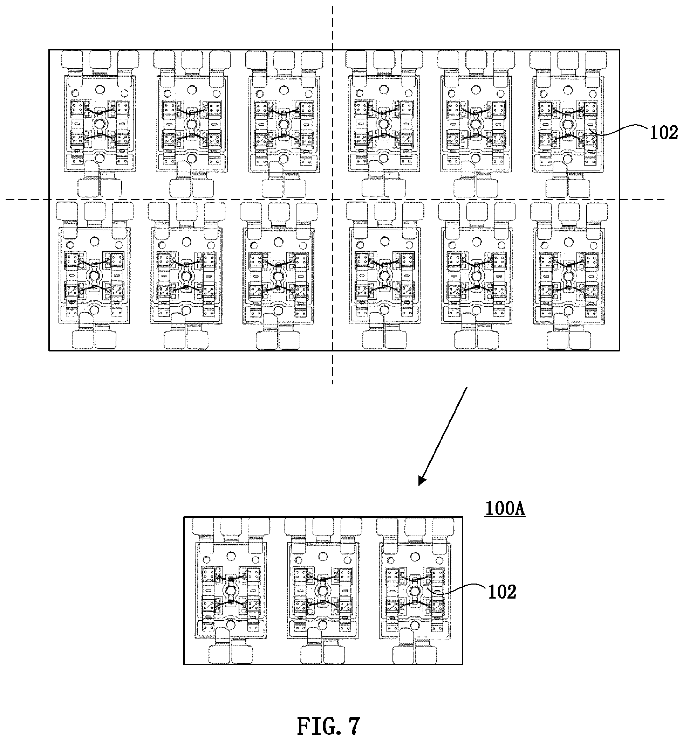

As an example, FIG. 7 schematically illustrates a schematic diagram of a step of separating the power modules from an intermediate unified structure, or system assembly. First, up to twelve power module units 102 are arranged in an array in the lead frame, then all the power module units 102 are collectively encapsulated by a molding compound, and finally the cured molding compound is cut into four power modules 100A, each power module 100A including three power module units 102. Such a manufacturing method enables a plurality of power modules including an arbitrary number of power module units to be obtained by a single encapsulating and cutting process, greatly improving the manufacturing efficiency of the power modules. In contrast, the plurality of power module units of the conventional power module are typically individually encapsulated and then welded together, resulting in a very cumbersome and expensive manufacturing method.

Returning to FIGS. 6A and 6B, in step S302, forming each power module unit may optionally include some or all of steps S310 through S370.

At step S310, the intra-cooling device 110 is formed of an insulating material, as shown in FIGS. 2A, 2B, 3B, 4C, and 4D.

At step S320, the first metal layer 120 and the second metal layer 130 are formed on the top surface and the bottom surface of the intra-cooling device 110, respectively, as shown in FIGS. 2A, 2B, 3B, 4C, and 4D.

At step S330, the first chip 140 and the second chip 150 are attached on the first metal layer 120 and the second metal layer 130, respectively, as shown in FIGS. 2A, 2B, 3B, 4C, and 4D.

At step S340, the first conductive clip 122 is attached on the first chip 140 and the first metal layer 120, and the second conductive clip 132 is attached on the second chip 150 and the second metal layer 130, as shown in FIGS. 2A, 2B, 3B, 4C, and 4D.

At step S350, the first conductive pillar 160 is attached on the first metal layer 120 to serve as a first signal lead for the first chip 140, and the second conductive pillar 170 is attached on the second metal layer 130 to serve as a second signal lead for the second chip 150, as shown in FIGS. 2A, 2B, 3B, 4C, and 4D.

At step S360, the first lead 180 is attached at an edge location of the first metal layer 120, the first lead 180 extending beyond the first metal layer 120 to serve as a first power supply lead for the first chip 140; and the second lead 190 is attached at an edge location of the second metal layer 130, the second lead 190 extending beyond the second metal layer 130 to serve as a second power supply lead for the second chip 150, as shown in FIGS. 2A, 2B and 3B.

At step S370, the first conductive wire 124 is attached on the first chip 140 and the first metal layer 120; and the second conductive wire 134 is attached on the second chip 150 and the second metal layer 130, as shown in FIGS. 2A, 2B, 3B, 4C, and 4D.

In some embodiments, one end of the first conductive pillar is exposed from the top surface of the molded housing to serve as a first signal lead contact for the first chip, and one end of the second conductive pillar is exposed from the bottom surface of the molded housing to serve as a second signal lead contact for the second chip.

In some embodiments, a portion of the first lead is exposed from a peripheral portion of the molded housing to serve as a first power supply lead contact for the first chip, and a portion of the second lead is exposed from a peripheral portion of the molded housing to serve as a second power supply lead contact for the second chip.

In some embodiments, step S360 (shown in a dashed box) may be omitted such that instead of using one or more additional leads as power supply lead(s) for the chip, one or more portions of the first and second metal layers can be used as power supply lead(s) for the chip. In such an embodiment, a first portion at an edge location of the first metal layer serves as a first power supply lead for the first chip, and a part of the first portion is exposed from a peripheral portion of the molded housing to serve as a first power supply lead contact for the first chip, and a second portion at an edge location of the second metal layer serves as a second power supply lead for the second chip, and a part of the second portion is exposed from a peripheral portion of the molded housing to serve as a second power supply lead contact for the second chip.

Those skilled in the art will appreciate that, while the flow diagrams of FIGS. 6A and 6B depict a particular order of execution of the steps, the order may be altered without departing from the scope of the present disclosure. Some of the depicted steps may be performed in parallel or in a different order that does not substantively affect the functionality of the process. For example, the execution order of the steps S340, S350, S360, and S370 may be arbitrarily exchanged as needed.

The present disclosure also contemplates an electrical system that may comprise one or more power modules according to any of the embodiments of the present disclosure. By way of example, the electrical system may comprise, for example, an inverter, a new energy vehicle, a wind power system, a solar power generation system, an energy storage system, and any other devices or systems that need to use the power module of the present disclosure.

As used herein, the word "chip" includes, but is not limited to, a die.

Terms "front", "back", "top", "bottom", "above", "below", and the like in the description and the claims, if any, are used for descriptive purposes and not necessarily for describing permanent relative positions. It should be understood that the terms so used are interchangeable where appropriate such that some embodiments of the present disclosure described herein, for example, can operate in other orientations different from those illustrated herein or otherwise described.

As used herein, a term "exemplary" means "serving as an example, instance, or illustration", and not as a "model" that is to be reproduced exactly. Any implementation exemplarily described herein is not necessarily to be construed as preferred or advantageous over other implementations. Furthermore, the present disclosure is not limited by any expressed or implied theory presented in the above TECHNICAL FIELD, BACKGROUND, SUMMARY, or DETAILED DESCRIPTION.

As used herein, a term "substantially" or "about" means encompassing any minor variations caused by imperfections in design or manufacturing, tolerances of components or elements, environmental effects and/or other factors. The term "substantially" or "about" also allows for differences from a perfect or ideal situation caused by parasitic effect, noise, and other practical considerations that may exist in a practical implementation.

In addition, the foregoing description may mention elements or nodes or features that are "connected" or "coupled" together. As used herein, unless expressly stated otherwise, "connected" means that one element/node/feature is directly connected with (or directly communicates with) another element/node/feature in an electrical, mechanical, logical, or other manner. Similarly, unless expressly stated otherwise, "coupled" means that one element/node/feature may be directly or indirectly connected with another element/node/feature in a mechanical, electrical, logical or other manner, to allow interaction, even if the two elements are not directly connected. That is, "coupled" is intended to include direct and indirect connections of elements or other features, including connection using one or more intermediate elements.

In addition, for reference purposes only, similar terms such as "first" and "second" can also be used herein, and thus are not intended to be limiting. For example, unless clearly indicated by the context, the terms "first", "second" and other such numerical terms involving structures or elements do not imply a sequence or order.

It should be further understood that a term "comprise/include", when used herein, specifies the presence of stated features, wholes, steps, operations, units, and/or components, but does not preclude the presence or addition of one or more other features, wholes, steps, operations, units, components, and/or combinations thereof.

In the present disclosure, a term "provide" is used broadly to encompass all ways of obtaining an object, and thus "providing an object" includes, but is not limited to, "purchasing", "preparing / manufacturing", "arranging / setting", "installing / assembling", and/or "ordering" the object, and so on.

As used herein, the term "a system assembly" refers to a composite structure that includes at least one of power module units, formed with a lead frame and molding compounds. The system assembly may correspond to an intermediate or final stage of fabrication and may include elements that are subsequently removed or altered during later manufacturing processes, such as trimming, bonding, sintering, welding, or cutting. The term encompasses both fully and partially assembled structures prior to integration into a finished product.

Those skilled in the art should realize that boundaries between the above operations are merely illustrative. Multiple operations can be combined into a single operation, a single operation can be distributed in additional operations, and the execution of the operations can be at least partially overlapped in time. Moreover, alternative embodiments can include multiple instances of specific operations, and the order of the operations may be altered in various other embodiments. However, other modifications, variations, and alternatives are also possible. Accordingly, this description and the accompanying drawings should be regarded as illustrative rather than restrictive.

Although some specific embodiments of the present disclosure have been described in detail through examples, it should be understood by those skilled in the art that the above examples are for illustration only and are not intended to limit the scope of the present disclosure. The embodiments disclosed herein can be combined arbitrarily without departing from the spirit and scope of the present disclosure. Those skilled in the art should also appreciate that various modifications can be made to the embodiments without departing from the scope and spirit of the present disclosure. The scope of the present disclosure is defined by the appended claims.

A power module is summarized as including one or more power module units each including: an intra-cooling device formed of an insulating material; a first metal layer disposed on a top surface of the intra-cooling device; a first chip attached on the first metal layer, the first chip being electrically coupled by the first metal layer and at least one of a first conductive clip and a first conductive wire attached on the first chip and the first metal layer; a second metal layer disposed on a bottom surface of the intra-cooling device; and a second chip attached on the second metal layer, the second chip being electrically coupled by the second metal layer and at least one of a second conductive clip and a second conductive wire attached on the second chip and the second metal layer.

Each power module unit further includes: a first conductive pillar attached on the first metal layer to serve as a first signal lead for the first chip; and a second conductive pillar attached on the second metal layer to serve as a second signal lead for the second chip.

The power module further includes: a molded housing formed by integrally fabricating for encapsulating the one or more power module units, wherein one end of the first conductive pillar is exposed from a top surface of the molded housing to serve as a first signal lead contact for the first chip; and wherein one end of the second conductive pillar is exposed from a bottom surface of the molded housing to serve as a second signal lead contact for the second chip.

The power module includes a plurality of power module units arranged in an array; and there is only a portion of the molded housing disposed between adjacent power module units.

Each power module unit further includes: a first lead attached at an edge location of the first metal layer and extending beyond the first metal layer to serve as a first power supply lead for the first chip; and a second lead attached at an edge location of the second metal layer and extending beyond the second metal layer to serve as a second power supply lead for the second chip, wherein a portion of the first lead is exposed from a peripheral portion of the molded housing to serve as a first power supply lead contact for the first chip; and wherein a portion of the second lead is exposed from a peripheral portion of the molded housing to serve as a second power supply lead contact for the second chip.

A first portion at an edge location of the first metal layer serves as a first power supply lead for the first chip, and a part of the first portion is exposed from a peripheral portion of the molded housing to serve as a first power supply lead contact for the first chip; and a second portion at an edge location of the second metal layer serves as a second power supply lead for the second chip, and a part of the second portion is exposed from a peripheral portion of the molded housing to serve as a second power supply lead contact for the second chip.

The intra-cooling device includes: a top insulating part formed by integrally fabricating, including a top cap; a bottom insulating part formed by integrally fabricating, including a box composed of a bottom cap and a plurality of sidewalls surrounding the bottom cap, wherein the top insulating part and the bottom insulating part are assembled together in such a manner that an inner surface of the top cap and an inner surface of the bottom cap face each other, thereby forming a cavity capable of accommodating a cooling liquid; and the cooling liquid accommodated in the cavity.

The intra-cooling device further includes one or all of: at least one first heat conductor disposed on the inner surface of the top cap and extending in a direction perpendicular to the inner surface of the top cap; and at least one second heat conductor disposed on the inner surface of the bottom cap and extending in a direction perpendicular to the inner surface of the bottom cap.

The at least one first heat conductor and the at least one second heat conductor are arranged in a staggered manner, such that respective heat conductors are spaced apart from each other by a certain distance in the cavity.

The plurality of sidewalls of the bottom insulating part are formed with sealing edges at their locations in contact with the top cap of the top insulating part, the sealing edges being capable of closely mating with edges of the top cap to seal the cavity.

The intra-cooling device further includes: a liquid inlet formed in the top cap of the top insulating part and in the first metal layer, wherein the cooling liquid flows into the cavity through the liquid inlet, and a liquid outlet formed in the top cap of the top insulating part and in the first metal layer, wherein the cooling liquid flows out of the cavity through the liquid outlet.

The at least one first heat conductor and the at least one second heat conductor include one or more of: a cylinder heat conductor, an elliptic cylinder heat conductor, a rectangular cylinder heat conductor, a regular polygonal cylinder heat conductor, an irregular cylinder heat conductor and a cone heat conductor; the attaching includes bonding together by sintering or welding using an electrically and/or thermally conductive material; the first chip and/or the second chip include a power chip; the first metal layer is formed on the top surface of the intra-cooling device by sintering, brazing, soldering or curing; and/or the second metal layer is formed on the bottom surface of the intra-cooling device by sintering, brazing, soldering or curing.

A manufacturing method for a power module is summarized as including: forming one or more power module units, wherein forming each power module unit includes: forming an intra-cooling device from an insulating material; forming a first metal layer and a second metal layer on a top surface and a bottom surface of the intra-cooling device, respectively; attaching a first chip and a second chip on the first metal layer and the second metal layer, respectively; attaching a first conductive clip on the first chip and the first metal layer; and attaching a second conductive clip on the second chip and the second metal layer.

Forming each power module unit further includes: attaching a first conductive pillar on the first metal layer to serve as a first signal lead for the first chip; and attaching a second conductive pillar on the second metal layer to serve as a second signal lead for the second chip.

Forming each power module unit further includes: attaching a first lead at an edge location of the first metal layer, the first lead extending beyond the first metal layer to serve as a first power supply lead for the first chip; and attaching a second lead at an edge location of the second metal layer, the second lead extending beyond the second metal layer to serve as a second power supply lead for the second chip.

Forming each power module unit further includes: attaching a first conductive wire on the first chip and the first metal layer; and attaching a second conductive wire on the second chip and the second metal layer.

The manufacturing method further includes: collectively disposing the one or more power module units in a lead frame; encapsulating the one or more power module units with a molding compound; and cutting the molding compound and the lead frame to obtain one or more power modules each having a respective molded housing after the molding compound is cured.

One end of the first conductive pillar is exposed from a top surface of the molded housing to serve as a first signal lead contact for the first chip; and one end of the second conductive pillar is exposed from a bottom surface of the molded housing to serve as a second signal lead contact for the second chip.

The manufacturing method further satisfies one of: wherein a portion of the first lead is exposed from a peripheral portion of the molded housing to serve as a first power supply lead contact for the first chip, and a portion of the second lead is exposed from a peripheral portion of the molded housing to serve as a second power supply lead contact for the second chip; or wherein a first portion at an edge location of the first metal layer serves as a first power supply lead for the first chip and a part of the first portion is exposed from a peripheral portion of the molded housing to serve as a first power supply lead contact for the first chip, and wherein a second portion at an edge location of the second metal layer serves as a second power supply lead for the second chip, and a part of the second portion is exposed from a peripheral portion of the molded housing to serve as a second power supply lead contact for the second chip.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A power module, comprising:
one or more power module units, each one of power module units comprising:
an intra-cooling device of an insulating material;
a first metal layer on a top surface of the intra-cooling device;
a first conductor;
a first chip on the first metal layer, the first chip coupled by the first metal layer and the first conductor attached on the first chip and the first metal layer;
a second metal layer on a bottom surface of the intra-cooling device;
a second conductor; and
a second chip on the second metal layer, the second chip coupled by the second metal layer and the second conductor attached on the second chip and the second metal layer.

2. A method, comprising:
forming one or more power module units, wherein forming each power module unit comprises:
forming an intra-cooling device from an insulating material;
forming a first metal layer and a second metal layer on a top surface and a bottom surface of the intra-cooling device, respectively;
coupling a first chip and a second chip on the first metal layer and a first conductor, and the second metal layer and a second conductor, respectively.

3. The power module of claim 1, or the method of claim 2, wherein:
the first conductor comprises a first conductive clip; and
the second conductor comprises a second conductive clip.

4. The power module of claim 1 or 3, or the method according to claim 2 or 3, wherein:
the first conductor further comprises a first conductive wire; and
the second conductor further comprises a second conductive wire.

5. The power module according to any of claims 1, 3 and 4, or the method according to any of claims 2 to 4, wherein each power module unit further comprises:
a first conductive pillar coupled on the first metal layer to serve as a first signal lead for the first chip; and
a second conductive pillar coupled on the second metal layer to serve as a second signal lead for the second chip.

6. The method according to claim 5, further comprising:
collectively disposing the one or more power module units in a lead frame;
encapsulating the one or more power module units with a molding compound; and
cutting the molding compound and the lead frame to obtain one or more power modules, each of the one or more power modules having a molded housing respectively after the molding compound is cured.

7. The power module according to claim 5, further comprising:
a molded housing that encapsulates the one or more power module units.

8. The power module of claim 7, or the method of claim 6:
wherein one end of the first conductive pillar is exposed from a top surface of the molded housing; and
wherein one end of the second conductive pillar is exposed from a bottom surface of the molded housing.

9. A system, comprising:
a lead frame supporting a plurality of power module units, each power module unit comprising:
an insulating intra-cooling device;
a first metal layer on a top surface of the intra-cooling device;
a first chip coupled to the first metal layer;
a second metal layer on a bottom surface of the intra-cooling device; and
a second chip coupled to the second metal layer;
a molded compound encapsulates the plurality of power module units;
at least one of a plurality of direct current (DC) terminals; and
at least one of a plurality of alternating current (AC) terminals, wherein the plurality of DC terminals and the plurality of AC terminals are arranged in a symmetrical orientation.

10. The power module according to claim 7 or 8, or the method according to claim 6 or 8, or the system according to claim 9,
wherein the power module units are in an array; and
wherein there is a portion of the molded housing disposed between adjacent power module units.

11. The power module according to any of claims 7, 8 and 10, or the method according to any of claims 6, 8 and 10, or the system according to claim 9 or 10, wherein each power module unit further comprises:
a first lead coupled at an edge location of the first metal layer and extending beyond the first metal layer to serve as a first power supply lead for the first chip; and
a second lead coupled at an edge location of the second metal layer and extending beyond the second metal layer to serve as a second power supply lead for the second chip,
wherein a portion of the first lead is exposed from a peripheral portion of the molded housing; and
wherein a portion of the second lead is exposed from the peripheral portion of the molded.

12. The power module according to any of claims 1, 3 to 5, or the methos according to any of claims 2 to 5, or the system according to claim 9 or 10,
wherein a first portion at an edge location of the first metal layer serves as a first power supply lead for the first chip, and a part of the first portion is exposed from a peripheral portion of the molded housing to serve as a first power supply lead contact for the first chip; and
wherein a second portion at an edge location of the second metal layer serves as a second power supply lead for the second chip, and a part of the second portion is exposed from a peripheral portion of the molded housing to serve as a second power supply lead contact for the second chip.

13. The power module or the method according to any of claims 1, 3 to 5, 7 to 10, or the method according to any of claims 2 to 6, 8 to 10, or the system according to any of claims 9 to 13, wherein the intra-cooling device comprises:
a top insulating part integrally includes a top cap; and
a bottom insulating part integrally includes a box having a bottom cap and a plurality of sidewalls surrounding the bottom cap;
a cooling liquid cavity that includes an inner surface of the top cap and an inner surface of the bottom cap that face each other.

14. The power module or the method or the system according to claim 13, wherein the intra-cooling device further comprises at least one of:
at least one first heat conductor finger disposed on the inner surface of the top cap and extending away from the inner surface of the top cap; and
at least one second heat conductor finger disposed on the inner surface of the bottom cap and extending away from the inner surface of the bottom cap.

15. The power module or the method or the system according to claim 14, wherein the at least one first heat conductor finger and the at least one second heat conductor finger are arranged in a staggered manner, such that heat conductors are spaced apart from each other, respectively, in the cavity.

16. The power module or the method or the system according to any of claims 13 to 15, wherein the plurality of sidewalls of the bottom cap are formed with sealing edges at their locations in contact with the top cap, the sealing edges being configured to closely mate with edges of the top cap.

17. The power module or the method or the system according to any of claims 13 to 16, wherein the intra-cooling device further comprises:
a liquid inlet in the top cap of the top insulating part and in the first metal layer, wherein the cooling liquid flows into the cavity through the liquid inlet, and
a liquid outlet in the top cap of the top insulating part and in the first metal layer, wherein the cooling liquid flows out of the cavity through the liquid outlet.

18. The power module or the method or the system according to any of claims 14, 15 or 16, 17 in their dependency on claim 14, wherein
the at least one first heat conductor finger and the at least one second heat conductor finger comprise one or more of: a cylinder heat conductor, an elliptic cylinder heat conductor, a rectangular cylinder heat conductor, a regular polygonal cylinder heat conductor, an irregular cylinder heat conductor and a cone heat conductor;
at least one of the first chip and the second chip comprise a power chip;
the first metal layer is formed on the top surface of the intra-cooling device by sintering, brazing, soldering or curing; and
the second metal layer is formed on the bottom surface of the intra-cooling device by sintering, brazing, soldering or curing.
